# EUROPEAN PATENT SPECIFICATION

(11) **EP 3 231 001 B1**
(45) Date of publication and mention of the grant of the patent: **05.02.2020**
(21) Application number: 14818927.7
(22) Date of filing: 11.12.2014
(51) Int. Cl.: H01J 37/04

(54) **ELECTROSTATIC BIPRISM**
ELEKTROSTATISCHES DOPPELPRISMA
BIPRISME ÉLECTROSTATIQUE

(43) Date of publication of application: 18.10.2017
(73) Proprietor: Forschungszentrum Jülich GmbH, 52425 Jülich (DE); Commissariat à l'énergie atomique et aux énergies alternatives, 38054 Grenoble cedex 9 (FR)
(72) Inventor: DUCHAMP, Martial, 639804 Singapore (SG); DUNIN-BORKOWSKI, Rafal Edward, 52428 Jülich (DE); GIRARD, Olivier, F-38120 Saint Egrève (FR); COOPER, David, F-38000 Grenoble (FR)
(74) Representative: dompatent von Kreisler Selting Werner - Partnerschaft von Patent- und Rechtsanwälten mbB
(86) International application number: PCT/EP2014/077393
(87) International publication number: WO 2016/091314

(56) References cited:
- WO-A2-03/068399
- JP-A- 2010 225 533
- KR-B1- 101 455 743
- DAUDERSTADT U ET AL: "Application of spatial light modulators for microlithography", PROCEEDINGS OF SPIE, S P I E - INTERNATIONAL SOCIETY FOR OPTICAL ENGINEERING, US, vol. 5348, no. 1, 26 January 2004 (2004-01-26), pages 119-126, XP002361368, ISSN: 0277-786X, DOI: 10.1117/12.528798 ISBN: 978-1-62841-467-7

## Description

The invention relates to an electrostatic biprism comprising a multilayer with a freestanding electrode, being preferably a multi-biprism, the method for preparing said electrostatic biprism and the use of said biprism within an electron beam device. The invention further relates to a microscope, an interferometer or an electron beam device comprising said electrostatic biprism.

Electron holography is holography with electron waves which allows to perform interference of an electron beam to recover the phase shift difference between the splitted beams. In electron holography an electron beam is split with an electron biprism in two separate beams, one of them is modulated by an object, and the other one is kept unmodulated, where after these two separate beams are superimposed on a screen to form an interference pattern, the so called electron hologram.

In general, electron holography is performed using a Möllenstedt-type electron biprism mounted in an electron microscope. The electron biprism works as a beam splitter for electrons and is construed of two earth electrodes facing each other and of a very thin wire electrode (filament) between them. Because the biprism is in the path of the electron beam and shadow part of the electron beam, the diameter of the filament is required to be as small as possible.

A quartz wire covered with metal or a platinum wire has often been used as a filament, but both need very careful handling and the diameter of the wire is restricted to visible size for being set by hand. To overcome these disadvantages, an ion beam thinning technique for comparatively thick platinum wire to obtain the wire of the desired diameter down to 0.15 µm has been proposed.

JP 2010-225533 A discloses a technology for forming tensioned fine aerial wiring, where the aerial wiring is formed by being irradiated with a first charged particle beam which is converged upon an area to which a material gas is supplied and the aerial wiring formed by being irradiated with the first charged particle beam is tensioned by being irradiated with a second charged particle beam.

However, there is still a need to further reduce the dimension of an electron biprism in order to increase the interference wide and/or the contrast in the interference pattern and thereby to achieve a higher resolution and sensibility of the interference patterns. Furthermore the current electron biprisms are difficult to handle, require complex and costly holder constructions and as a result are not suitable for the proper generation of a multi-biprism, with several filaments lined in parallel.

Finally, the use of a filament and the parallel lined earth electrodes constitutes a restriction with regard to the form of the biprism, e.g. other forms as the filamentous form of the inner electrodes are not possible.

Hence, there is still a need for an improved electron biprism. The objective of the present invention thus is to provide an electrostatic biprism which overcomes at least one of the above mentioned disadvantages.

This problem is solved by provision of an electrostatic biprism according to claim 1. Specific embodiments are subject matter of further independent or dependent claims.

### SUMMARY OF THE INVENTION

According to the invention as claimed, the invention provides an electrostatic biprism according to claim 1 and a respective method of producing it according to claim 10, the electrostatic biprism comprising a first conductive layer arranged on a second non-conductive layer, whereby at least one area of said first conductive layer forming the inner electrode is electrically isolated from two adjacent areas of said first conductive layer, whereby said inner electrode is formed as a freestanding electrode.

The core aspect of the invention is the finding that the inner electrode of a biprism can be provided as freestanding electrode of a thin layer of conductive material optionally coated with a metallic layer.

As a freestanding electrode the biprism allow a precise and homogenous scattering/deflection since there is no underlying layer which might lead to additional scattering.

The electrostatic biprism of the invention can be produced by any microelectronic and nanoelectronic fabrication method. Accordingly, the biprism can be produced use the well-known semiconductor fabrication procedures allowing to establish precise nano-scaled structures with defined layer composition and layer thickness.

As a result the width/cross section of the inner electrode can be less than 100 nm allowing electron holography with higher resolution and sensibility. Furthermore this aspect will allow to deflect the electron beam for low applied voltage which rather should reduce the perturbation of the electron beam.

A further advantage arises from the possibility to prepare the biprism of the invention with walls possessing a high smoothness. This should produce a homogenous electrical field perpendicular to the electron beam direction.

For the electron biprism of the prior art it is necessary to record a reference image which has to be subtracted from the data image in order to eliminate the deviations caused by the imperfection of the electron biprism. With the biprism of the invention this additional step is not any more required, accelerating and facilitating the process of electron holography.

The fabrication procedures of the present invention allow to generate all kind of structures and forms. Hence, the form restriction of filaments as wires with a defined diameter is not any more given. For example, the filament of the prior art biprism has a circular cross section, whereas the biprism of the invention could be generated with alternative formed cross sections.

Furthermore, the biprisms of the prior art with a circular cross section possess an aspect ratio (i.e. the ratio between width and height) of 1:1. In contrast the aspect ratio of the inner electrode of the biprism according the invention can be tuned with an aspect ratio of 1:10 (width : height) or even more. It has to be noted that not only the diameter of the inner electrode but also the aspect ratio is a key factor for determining the interference wide and the contrast of the interference pattern.

The new forms that can be generated with the biprism of the invention with more freedom and with high accuracy open the door for completely new applications. As an example, a given set of freestanding half biprisms of the invention can be used to creating a vortex electron beam.

Furthermore, in a classical Möllenstedt biprism the inner filamentous electrode is surrounded by two parallel arranged earth electrodes. In the biprism of the invention the form of the space between the inner electrode and the earth electrodes can be freely chosen allowing novel arrangements with improved prismatic properties.

Furthermore, the biprism of the invention can be easily formed as multiprism or even as a 3-dimensional (3-D) device whereby several biprismatic structures are placed on above the other.

In a preferred embodiment, said 3-D device is an X-biprism, whereby two electron biprisms are located one above the other and normal to each other.

By using additional layers as a support layer, a separate biprism holder is not required any more. Advantageously, the biprism of the invention can be constructed as single-piece devices including the function of the biprism and the respective holder.

In sum, the biprism of the invention allow to produce mechanically stable and extremely small electrodes without design limitations.

### DETAILED DESCRIPTION OF THE INVENTION

The electrostatic biprism of the invention can be used to scatter or deflect any charged particle ranging from elementary particles, electrons, monoatomic ions to polyatomic ions. Most preferably, the electrostatic biprism is used for an electron beam and accordingly represents an electron biprism.

In a preferred embodiment of the invention the first conductive layer of the electrostatic biprism is a crystalline layer. In general, a crystalline material possesses higher stability compared to the respective amorphous material. As a consequence the conductive layer exhibits improved material stability.

The crystalline layer can be a polycrystalline layer or a monocrystalline layer, whereby a monocrystalline layer is preferred. In a more preferred embodiment the first conductive layer is a layer of monocrystalline silicon. The monocrystalline silicon (synonymous to "single-crystal silicon") is silicon in which the crystal lattice of the entire solid is essentially continuous, unbroken to its edges, and free of any grain boundaries. Monocrystalline silicon can be prepared intrinsic, consisting only of exceedingly pure silicon, or doped, containing very small quantities of other elements added to change its semiconducting properties.

According to the invention a doped monocrystalline silicon layer as first conductive layer is most preferred.

In one embodiment of the invention the thickness of said first conductive layer of the electrostatic biprism is between 10 nm and 1 mm, preferably between 0.1 µm and 10 µm and more preferably between 0.5 and 2 µm. It has to be noted that the thickness of the first conductive layer defines the height of the inner electrode of the electrostatic biprism.

In a further embodiment of the invention, the thickness of the second non-conductive layer of the electrostatic biprism is between 1 nm and 100 µm, preferably between 25 nm and 500 nm and more preferably between 50 and 200 nm. Since the function of the second non-conductive layer is to act as a carrier insulator layer for the first conductive layer, its thickness is given by the minimal stability required for the supportive function.

According to the invention, the second non-conductive layer is arranged on a third substrate layer, i.e. the support layer. The substrate layer further add to the stability of the biprism and allow the formation of more complex structures, due to the partial or section wise removal of said substrate layer.

According to an embodiment of the invention said support layer has a thickness of between 1 nm and 10 mm, preferably of between 100 nm and 5 mm and more preferably of between 500 µm and 1 mm.

As stated above the first conductive layer comprises a form that can be produced to suit any form. Preferably forms include a spiral, a circle, co-centric-circles and a rectangle.

Hereby, the most preferred form is the rectangular form mimicking the filamentous structure of the inner electrode.

Typically, said form defines the subarea of the first conductive layer that forms the inner electrode. Accordingly, it is the form of the inner electrode that is shaped as a spiral, a circle, co-centric-circles and a rectangle.

For acting as a biprism the area of the conductive layer forming the inner electrode has to be electrically isolated from the adjacent areas of the conductive layer, thereby representing the earth electrodes. In another embodiment the electrical isolation between the two areas is given by inserting a non-conductive material between the two areas. According to the invention, this electrical isolation is given by physical separation of these two areas of the first conductive layer, leaving a gap or space between them.

In a preferred embodiment of the invention, said physical separation between the area forming the inner electrode and the two adjacent areas is expanded by a recess of the inner electrode and/or the adjacent area. Hereby, the recess defines the gap between the inner electrode and the adjacent earth electrodes. Most preferably, it is the inner electrode that exhibits the recess. Since the inner electrode is surrounded by two adjacent areas it typically exhibits two recesses, which are preferably of identical dimension. As a result, the inner electrode preferably has an H-like form with the broader area as electrical junction and a smaller area representing the inner electrode.

Accordingly, these two areas of the conductive layers possess two different gaps between them; a small gap in the peripheral parts of the areas and a larger centrally located gap built by the above stated recess in said central part of the areas.

The recess of the inner electrode and/or the adjacent area can be of any suitable form. Preferred forms include but are not limited to rectangular, trapezoid, triangular or circular.

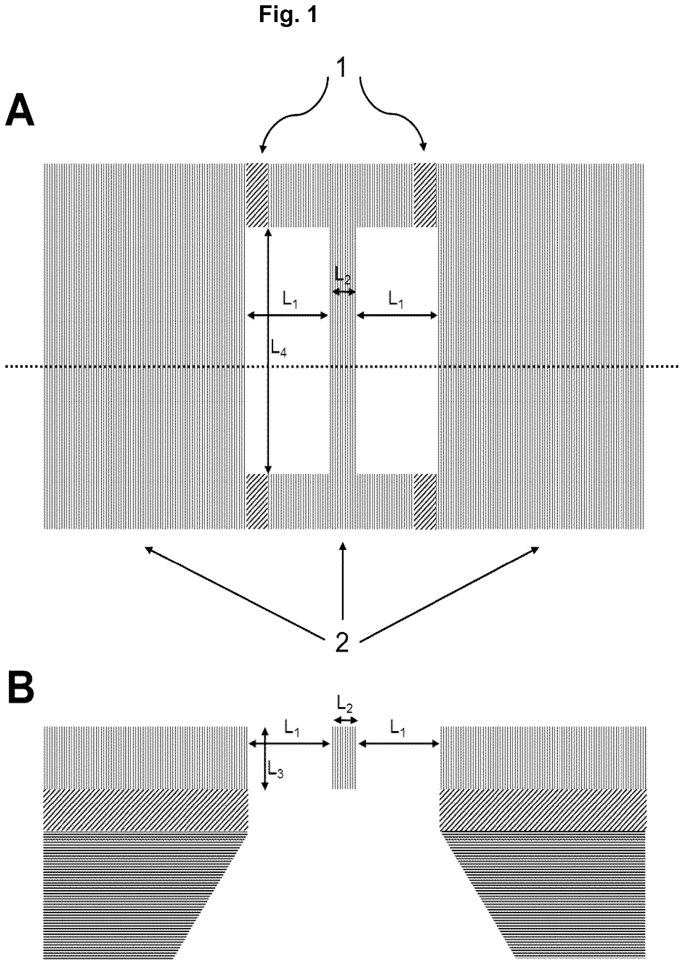

Preferably, a rectangular shaped recess is used for the biprism, whereby the inner electrode but not the adjacent areas exhibit the recess. The form of said rectangular recess is defined by a length L4, a width L1 and a breadth L2 of the remaining first conductive layer (see Figure 1).

In one embodiment of the invention the rectangular recess exhibits one or more of the following characteristics:
a. the length L4 is in a range between 1 nm and 10 mm, preferably between 1 µm and 1 mm and most preferably between 1 µm and 200 µm; and/or
b. the width L1 is in a range between 1 nm and 10 µm, preferably between 10 nm and 1 µm and most preferably between 50 nm and 500 nm; and/or
c. the breadth L2 of the remaining first conductive layer is in a range between 1 nm and 100 µm, preferably between 10 nm and 10 µm and most preferably between 50 nm and 500 nm.

Notably, the biprism of the invention allows to produce inner electrodes with a width of less than 500 nm and even up to 50 nm. In a specific embodiment the inner electrode has a width of 50 nm and a length of between 1 and 5 mm, preferably between 2 and 3 mm and most preferably of 2.5 mm.

In one embodiment of the invention the inner electrode of the biprism possess an aspect ratio (i.e. the ratio between width and height) of less than 1:1, preferably of less than 1:5 and more preferably of less than 1:10. Typically, the aspect ratio is between 1:2 and 1:20, preferably between 1:5 and 1:15 and more preferably between 1:8 and 1:12. Notably, in the field of electron holography, the aspect ratio is a key factor for determining the interference wide and the contrast of the interference pattern.

According to the invention, the supportive layer exhibits at least one cavity, preferably leaving the area forming the inner electrode uncovered from the support layer.

In one specific embodiment of the invention the electrostatic biprism contains 2 to 1000 areas of an inner electrode isolated from two adjacent areas of said first conductive layer, preferably 2 to 100 areas, more preferably 2 to 10 areas and most preferably 2 to 5 areas. Due to the multiple appearances of inner electrodes and adjacent areas as earth electrodes a multi biprism is formed. In one embodiment the core assembly of inner electrode (IE) and two adjacent areas (=earth electrodes; EE) is multiplied so that the following order of areas is given:

EE-IE-IE-EE-IE-EE-EE-IE-EE-IE EE...

In a more preferred embodiment the earth electrode can function as a counter electrode for two adjacent inner electrodes so that the following order of areas is given:

EE-IE-EE-IE-EE-IE-EE...

In such a multi-biprism the inner electrodes and the earth electrodes are preferably lined in parallel.

In a multi-biprism the individual biprisms can be of identical form and/or dimensions, whereby the inner electrodes and the adjacent earth cathodes are preferably all lined in parallel. In an alternative embodiment of the invention the individual biprisms possess different shapes or forms thereby enabling different paths for the electron beam. This allows the possibility that the different paths which are available to the electron beam can be exposed to the electromagnetic field with different amplitude, frequency and/or phase shift.

The electrostatic biprism of the invention can be produced by any microelectronic and nano-electronic fabrication method and typically by a method that is used for the production of semiconductor devices. In semiconductor device fabrication, the various processing steps fall into four general categories: deposition, removal, patterning, and modification of electrical properties.

Deposition is any process that grows, coats, or otherwise transfers a material onto a base layer. Available technologies include physical vapour deposition (PVD), chemical vapour deposition (CVD), electrochemical deposition (ECD), molecular beam epitaxy (MBE) and more recently, atomic layer deposition (ALD) among others.

Removal is any process that removes material from layered material; examples include etch processes (either wet or dry) and chemical-mechanical planarization (CMP).

Patterning is the shaping or altering of deposited materials, and is generally referred to as optical lithography or electron beam lithography. For example, in conventional lithography, the base layer is coated with a chemical called a photoresist; then, a machine called a stepper focuses, aligns, and moves a mask, exposing select portions of the base layer below to short wavelength light; the exposed regions are washed away by a developer solution. After etching or other processing, the remaining photoresist is removed by plasma ashing.

Modification of electrical properties has historically entailed doping transistor sources and drains (originally by diffusion furnaces and later by ion implantation). These doping processes are followed by furnace annealing or, in advanced devices, by rapid thermal annealing (RTA); annealing serves to activate the implanted dopants. Modification of electrical properties now also extends to the reduction of a material's dielectric constant in low-k insulators via exposure to ultraviolet light in UV processing (UVP).

The metal layer as optional element of the biprism of the invention can be made from any conductive metal. The metal layer on top of the conductive layer facilitates the electrical contact between the biprism and the external hardware. In the context of the present invention the conductive metal comprises not only pure metals but also doped metals and alloys.

In a preferred embodiment the metal layer consists of a metal selected from the group consisting of Al, AISi, Pt, Au and Ni.

The first conductive layer of the biprism can be made from any conductive material, including but not limited to metals, superconductors, semiconductors, nonmetallic conductors such as graphite and conductive polymers. The first conductivity layer has a conductivity of 10⁻⁶ S · m⁻¹ or more, preferably of 10⁻² S · m⁻¹ or more and more preferably of 10 S · m⁻¹ or more. In a preferred embodiment the conductive layer consists of a metal or a semiconductor, whereby silicon (Si), an aluminium alloy or platinum (Pt) are more preferred.

The aluminium alloy preferably consists of a material selected from the group consisting of AlCuMg, AlCuSiMn, AlMgSi, AlZnMg, AlZnMgCu, AISi, AlSiMg, AlSiCu, AIMg, AlMgSi, AlCuTi, AlCuTiMg, whereby AISi is of further preference. More preferably, a hypereutectic AISi alloy is used. For the AISi alloys it is known that increasing the Si content results in an increase of the strength of hypoeutectic alloys and a decrease of the strength of hypereutectic alloys.

The second non-conductive layer of the biprism of the invention can be made from any non-conductive, i.e., insulator material. An insulator material is a material whose internal electric charges do not flow freely, and therefore make it very hard to conduct an electric current under the influence of an electric field. In a preferred embodiment the non-conductive material is a metal oxide or metal nitride. In a more preferred embodiment said second non-conductive layer, consists of a material selected from the group consisting of SiO₂, Si₃N₄, and HfO₂, whereby SiO₂ is the most preferred material.

The support layer can be made of any material that is suitable for nanofabrication. Preferably it consists of a material selected from the group consisting of mono- or polycrystalline silicon, GaAs, GaN, Al₂O₃, Pt and Al.

In a specific embodiment of the invention the electrostatic biprism of the invention has the following layer structure:
- Outer metal layer consisting of Pt or Au;
- First conductive layer consisting of doped monocrystalline Si;
- Second non-conductive layer consisting of SiO₂;
- Support layer consisting of monocrystalline Si.

In one aspect the invention provides a method of producing an electrostatic biprism comprising the following steps:
a. providing a layer of a conductive material coated onto a layer of a non-conductive material on top of a support layer,
b. performing a photo/electron beam lithographic process, optionally combined with etching and/or oxidation steps, in order to provide an electrostatic biprism as claimed in claim 1.

In an embodiment a silicon-on-sapphire (SOS) substrate is used in step a.

SiO₂-based SOI wafers can be produced by several methods:
- The SIMOX method (Separation by Implantation of Oxygen) uses an oxygen ion beam implantation process followed by high temperature annealing to create a buried SiO₂ layer.
- In Wafer bonding method the insulating layer is formed by directly bonding oxidized silicon with a second substrate. The majority of the second substrate is subsequently removed, the remnants forming the topmost Si layer. Prominent examples of wafer bonding methods are the Smart Cut method, the Nanocleave technology and the ELTRAN technology.
- Seed methods are characterized by the fact that the topmost Si layer is grown directly on the insulator. Seed methods require some sort of template for homoepitaxy, which may be achieved by chemical treatment of the insulator, an appropriately oriented crystalline insulator, or vias through the insulator from the underlying substrate.

In a further embodiment of the invention the method of producing the electrostatic biprism according to claim 10 comprises the following steps:
a. Provision of a silicon-on-insulator (SOI) substrate, whereby the silicon is preferably mono-crystalline silicon and the insulator is preferably SiO₂;
b. using lithography tools alignment marks position and design are defined in a photo-resist layer, then the exposed Si top layer of the SOI (not protected by the photo resist) is totally or partially etched using plasma etch tool and then the photo-resist is removed using plasma and/or wet benches. As a result the alignment marks are defined inside the top Si layer of the SOI.;
c. Then using lithography tools bi prism position and design are defined in a photo-resist layer, then the exposed Si top layer of the SOI (not protected by the photo resist) is totally etched using plasma etch tool down to the buried insulator layer and then the photo-resist is removed using plasma and/or wet benches. Thereby the inner electrode is defined and isolated from outer electrode by the trenches. If alignment marks is made of totally etched top Si layer then steps b and c are merged: The lithography step is defining alignment marks and bi prism positions and designs.;
d. Oxidising the top Si layer using furnace with oxidizing gazes such as O₂ or H₂O. This defines the final dimension of the inner electrode and the gap between inner and outer electrode.
e. Then using lithography tools that allows back side to front side alignment, a back side cavity position and design are defined in a photo-resist layer, then the exposed Si bottom layer of the SOI (not protected by the photo resist) is totally etched using plasma DRIE etch tool or preferably wet chemical etch down to the buried insulator layer and then the photo-resist is removed using plasma and/or wet benches.;
f. Performing an oxide isotropic etching by wet or vapour HF to remove accessible oxide layers in order to release the area of the inner electrode and the buried insulator layer between said area and the back-side cavity;
g. Optionally depositing a metal layer on the surface of the silicon top layer either in evaporation or a PVD tool.

In a still further embodiment of the invention the method of producing the electrostatic biprism according to claim 10 comprises the following steps:
a. Provision of a mono- or polycrystalline silicon substrate layer;
b. Building the second non-conductive layer either by oxidizing the Si top surface using a furnace or by depositing a SiO₂ layer using either LPCVD or PECVD tool.,
c. Deposition of a polycrystalline silicon layer on top of the non-conductive SiO₂-layer by epitaxy or by low pressure chemical vapour deposition (LPCVD) to generate said first conductive layer;
d. using lithography tools alignment marks position and design are defined in a photo-resist layer, then the exposed Si top layer of the SOI (not protected by the photo resist) is totally or partially etched using plasma etch tool and then the photo-resist is removed using plasma and/or wet benches: alignment marks are defined inside the top Si layer of the SOI.;
e Then using lithography tools bi prism position and design are defined in a photo-resist layer, then the exposed Si top layer of the SOI (not protected by the photo resist) is totally etched using plasma etch tool down to the buried insulator layer and then the photo-resist is removed using plasma and/or wet benches: inner electrode is defined and isolated from outer electrode by the trenches. Lf alignment marks is made of totally etched top Si layer then steps band c are merged: The lithography step is defining alignment marks and bi prism.,
f. Then the top Si layer is oxidized using furnace with oxidizing gazes such as O₂ or H₂O. This defines the final dimension of the inner electrode and the gap between inner and outer electrode.;
g. Then using lithography tools that allows back side to front side alignment, a back side cavity position and design are defined in a photo-resist layer, then the exposed Si bottom layer of the SOI (not protected by the photo resist) is totally etched using plasma DRIE etch tool or preferably wet chemical etch down to the buried insulator layer and then the photo-resist is removed using plasma and/or wet benches.;
h. Performing an oxide isotropic etching by wet or vapour HF to remove accessible oxide layers in order to release the area of the inner electrode and the buried SiO₂ layer between said area and the back-side cavity;
i. Optionally depositing a metal layer on the surface of the silicon top layer either in an evaporation or a PVD tool.

The substrate as provided in step a) is preferably mono crystalline to benefit of slopes in the back side cavity, whereas a poly-crystalline substrate is more cost-efficient.

The electrostatic biprism can be used for any application which requires a beam splitter or an electrostatic deflection of charged particles. These charged particles could be molecules, atoms or even elementary particles.

In the most preferred embodiment the electrostatic biprism is used as an electronic biprism within an electron beam device, which typically comprises an electron gun (consisting of a cathode, grid, and anode) which is used to generate and accelerate the primary beam, an electromagnetic optical focusing and/or deflection system and a target for the electron beam.

The electrostatic biprism can be used for every application for which a deflection or scattering of charged particles is required.

In a preferred embodiment the respective electron beam device is used for electron holography, filtering energy, transmission electron microscopy, generation of vortex electron beams, aberration corrections or phase plate.

In the field of electron holography, the electron biprism of the invention can be used for a scanning transmission electron microscope (STEM) or a transmission electron microscope (TEM).

In a further aspect the invention provides an electron beam device comprising an electron biprism according to the invention.

In another aspect the invention provides a microscope or interferometer comprising an electron biprism according to the invention.

### DEFINITIONS

Electrostatic biprism in the context of the present invention is a device that allows a scattering or deflection of a beam of charged particles such as ions of molecules or atoms or elementary particles to generate two different beams of particles. For the preferred use of an electron beam the electrostatic biprism is denominated as an electron biprism.

The inner electrode is the central electrode of an electrostatic biprism that in interaction with the two adjacent earth/ground electrodes builds an electromagnetic field for deflection or scattering of the charged particles.

As defined herein the freestanding electrode is the area of the conductive layer which has no underlying non-conductive layer and also no underlying support layer. As a result, the freestanding electrode is only attached by its two ends to the peripheral conductive layer, whereas alongside the inner electrode (optionally coated with a metal layer) it stands free from any material, especially from the second non-conductive layer. It has to be pronounced that the freestanding electrode still can be coated by the metal layer. In general, the freestanding electrode mimics the filament of the prior art electron biprism.

In the context of the present invention a "conductive layer" which is synonymous to an electronically conductive layer, encompasses any conductive material, including but not limited to metals, superconductors, semiconductors, nonmetallic conductors such as graphite and conductive polymers. As a conductive layer it has a conductivity σ which is 10⁻⁶ S · m⁻¹ or more.

According to the present invention the "non-conductive layer" is a layer with electrically non-conductive or insulating properties. Hence it represents a material whose internal electric charges do not flow freely, and therefore make it very hard to conduct an electric current under the influence of an electric field. As such it has a resistance p of at least 10⁴ Ω · m.

### EXAMPLES

### 1. Preparation of an electronic biprism made of mono crystalline silicon

### Provision of a layered structure as basis

For the preparation a silicon-on-insulator (SOI) substrate is provided, with a silicon bottom layer, a thin SiO₂ layer (so called SiO₂ box) and a top silicon layer, whereby the thickness of the top silicon layer corresponds to the targeted height of the biprism plus the thickness of the layer that is lost because of oxidative fabrication steps. In order to modify the thickness of the top silicon layer the thickness of said layer can be increased by an additional epitaxy step or conversely decreased in thickness by an additional oxidation step with subsequent oxide etching process.

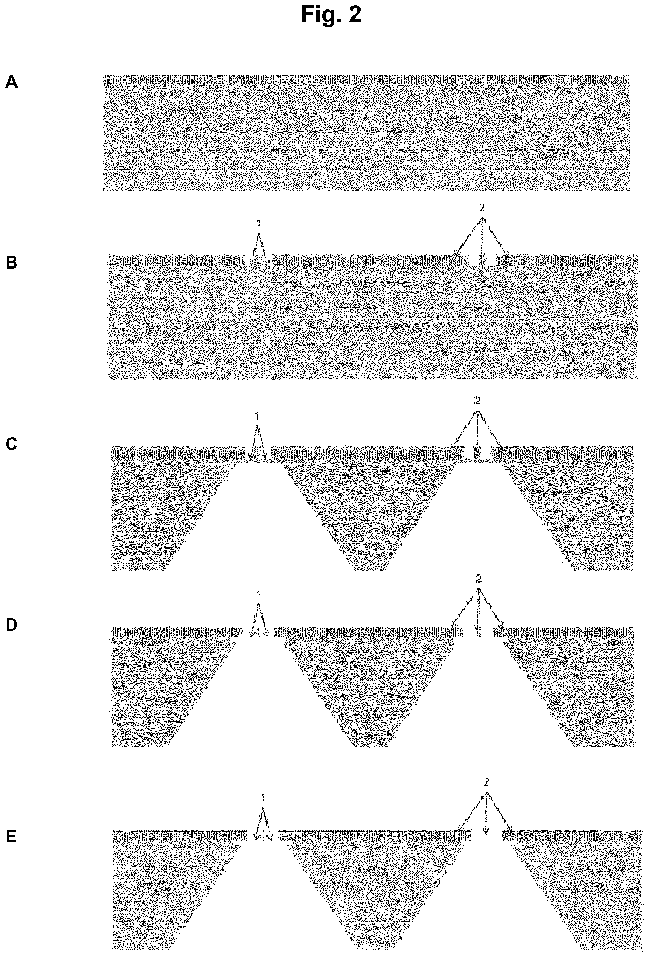

### Etching of alignment patterns (see Fig. 2A)

In a first step alignment patterns are etched into the surface of the top Si layer to ensure a correct front to back side alignment.

### Etching of the biprismatic structures (see Fig. 2B)

In the next step the top Si layer is etched down to the buried SiO₂ layer to create the biprismatic structures and oxidised thereafter.

### Etching of the back side cavities (see Fig. 2C)

In this next step back side cavities are created by chemical Si etching resulting in slopes that depend upon the choice of crystallographic orientation of the Si substrate. Slope for <100> orientation is equal to 54°7. If back side cavity is etched using DRIE the resulting slope is very close to 90°.

### Isotropic etching to release the biprism (see Fig. 2D)

By performing an isotropic oxide etch, either by wet or vapour HF the biprism is exposed and furthermore the SiO₂ box layer between the biprism and the back side cavity is removed. As a result a free-standing electrode is generated.

### Coating of the biprism with a thin metal layer (see Fig. 2E)

Optionally a thin metallic layer can be deposited on the surface of the Si top layer to facilitate the electrical contact between the biprism and the external hardware.

### 2. Preparation of an electron biprism made of poly-crystalline silicon

If the biprism is made starting from poly-crystalline silicon, the starting material would be a Si substrate layer. In a first oxidation step the non-conductive layer is generated on top of the Si substrate layer. Thereafter, deposition of a polycrystalline silicon layer on top of the non-conductive SiO₂ layer is performed by epitaxy or by low pressure chemical vapour deposition (LPCVD) to generate the first conductive layer. The resulting SOI substrate can be further processed as described in Example 1. Although the final device exhibits reduced mechanical stability, this process benefits from lower production costs.

### 3. Preparation of an electron biprism using different conductive materials.

For the both processes as described above alternative conductive materials could be used, in particular Al, AISi or Pt. For the process described above, the poly-crystalline Si may be replaced by a metallic layer. The process flow would then be:
a) Provision of a Si substrate preferably mono-crystalline
b) Building the second non-conductive layer either by oxidizing the Si top surface using a furnace or by depositing a SiO₂ layer using either LPCVD or PECVD tool. An alternative is to deposit a dielectric like Si₃N₄ or HfO₂, provided that it can be selectively etched versus the metallic layer and the Si substrate.
c) Depositing the conductive metallic layer either by PVD or evaporation tool.
d) Then using lithography tools alignment marks and bi prism position and design are defined in a photo-resist layer, then the exposed metallic top layer (not protected by the photo resist) is totally etched using plasma etch tool down to the buried insulator layer and then the photo-resist is removed using plasma and/or wet benches: alignment marks and inner electrode is defined and isolated from outer electrode by the trenches.
e) Then using lithography tools that allows back side to front side alignment a back side cavity position and design are defined in a photo-resist layer, then the exposed back side of the Si substrate (not protected by the photo resist) is totally etched using plasma DRIE etch tool or preferably wet chemical etch down to the buried insulator layer. A single side etch tool is preferably used to perform back side cavity etch to prevent any damage of the front side bi prism. Then the photoresist is removed using plasma and/or wet benches.
f) Performing an oxide isotropic etching by wet or vapour HF to remove accessible oxide layer in order to release the area of the inner electrode and the buried SiO₂ layer between said area and back side cavity. The advantage of Si or poly-Si material is that the minimum dimension achievable with standard etch tools is smaller than what is achievable for metallic layers. The advantage of metallic layer is reduction of resistivity that facilitates the evacuation of charges build up by electron beam.

### FIGURES

- Fig. 1A:: Top view on a schematically drawn electrostatic biprism with a free-standing inner electrode adjacent to earth electrodes both made from a conductive layer (2). The filament-shaped inner electrode as part of the conductive layer is generated by a rectangular recess of the conductive (2) layer and non conductive layer (1) with a length L4, a width L1 and a breadth L2. The conductive layer (2, horizontal stripes) is given on top of a non-conductive layer(1, diagonal stripes) which in turn is given on top the support layer (not visible from above, vertical stripes).
- Fig. 1B:: Cross section of the electrostatic multi-biprism of Fig. 1A alongside the dotted line. The cross section shows the free-standing inner electrode with a height L3 adjacent to the conductive layer as earth electrode. The conductive layer is given on top of a non-conductive layer which in turn is given on top the support layer. The support layer possesses cavities in order to release the inner electrodes.
- Fig. 2:: Process steps for preparing an electronic biprism made of mono crystalline silicon, as described in Example 1 showing: the etching of alignment patterns into the surface of the top Si layer of the SOI substrate **(A);** the etching of the top Si layer down to the buried SiO₂ layer with subsequent oxidation to create the biprismatic structures **(B);** etching of the back side cavities **(C);** release of the biprism and removal of the SiO₂ box layer by isotropic etching **(D);** coating of the biprism with a thin metal layer **(E).**

## Claims

1. Electrostatic biprism allowing a scattering or deflection of a beam of charged particles to generate two different beams of particles comprising a first conductive layer, preferably a mono or poly-crystalline layer, arranged on a second non-conductive layer, which is arranged on top of a support layer, whereby at least one area of said first conductive layer forming an inner electrode as a central electrode of the electrostatic biprism is electrically isolated from two adjacent areas of said first conductive layer, whereby said support layer possesses a cavity underneath said inner electrode being formed as a freestanding electrode with no underlying non-conductive layer and no underlying support layer and with gaps between the inner electrode and the two adjacent areas of the first conductive layer.

2. Electrostatic biprism according claim 1, whereby the thickness of said first conductive layer defining the height of the inner electrode of the electrostatic biprism is between 10 nm and 1 mm, preferably between 0.1 µm and 10 µm and more preferably between 0.5 and 2 µm,
and/or.
the thickness of said second non-conductive layer is between 1 nm and 100 µm, preferably between 25 nm and 500 nm and more preferably between 50 and 200 nm

3. Electrostatic biprism according to any of the above claims, whereby the support layer has a thickness of between 1 nm and 10 mm, preferably 100 nm and 5 mm and more preferably 500 µm and 1 mm.

4. Electrostatic biprism according to any of the above claims, whereby the area of the first conductive layer encompasses a form selected from the group consisting of a spiral, a circle, co-centric-circles and rectangle.

5. Electrostatic biprism according to any one of the above claims, whereby the gap between the area forming the inner electrode and the two adjacent areas is expanded by a recess of the inner electrode and/or the adjacent areas,
preferably the recess is rectangular, triangular or circular with a lateral length L4 within the first conductive layer, a lateral width L1 within the first conductive layer and a lateral breadth L2 of the remaining first conductive layer of the freestanding electrode.

6. Electrostatic biprism according to claim 5, whereby an aspect ratio between the breadth L2 and a height L3 of the freestanding inner electrode is less than 1:1, preferably less than 1:5, more preferably less than 1:10;
or
said electrostatic biprism exhibits one or more of the following characteristics:
(a) the length L4 is in a range between 1 nm and 10 mm, preferably between 1 µm and 1 mm and most preferably between 1 µm and 200 µm;
(b) the width L1 is in a range between 1 nm and 10 µm, preferably between 10 nm and 1 µm and most preferably between 50 nm and 500 nm;
(c) the breadth L2 of the remaining first conductive layer is in a range between 1 nm and 100 µm, preferably between 10 nm and 10 µm and most preferably between 50 nm and 500 nm.

7. Electrostatic biprism according to any one of above claims, whereby the substrate layer exhibits at least one cavity.

8. Electrostatic biprism according to any of the above claims, whereby the Electrostatic prism contains 2 to 1000 areas of an inner electrode isolated from two adjacent areas of said first conductive layer, preferably 2 to 100 areas, more preferably 2 to 10 areas and most preferably 2 to 5 areas.

9. Electrostatic biprism according to any one of the above claims, whereby said electrostatic biprism exhibits one or more of the following characteristics:
(a) A metal layer is deposited on top of the first conductive layer, preferably consisting of a metal selected from the group consisting of Al, AISi, Pt, Au and Ni;
(b) The first conductive layer consists of a material selected from the group consisting of Si, AISi, and Pt;
(c) The second non-conductive layer consists of a material selected from the group consisting of SiO₂, Si₃N₄, and HfO₂;
(d) The support layer consists of a material selected from the group consisting of mono- or polycrystalline silicon, GaAs, GaN, Al₂O₃, Pt and Al.

10. Method of producing an electrostatic biprism according to claim 1, comprising:
(a) providing a layer of a conductive material coated onto a layer of a nonconductive material on top of a support layer;
(b) performing a photo/electron beam lithographic process, optionally combined with etching and/or oxidation steps, in order to provide at least one area of said first conductive layer forming an inner electrode as a central electrode of the electrostatic biprism being electrically isolated from two adjacent areas of said first conductive layer, whereby said support layer possesses a cavity underneath said inner electrode being formed as a freestanding electrode with no underlying non-conductive layer and no underlying support layer and with a gap between the inner electrode and the two adjacent areas of the first conductive layer.

11. Method of producing an electrostatic biprism according claim 10, comprising:
(a) Provision of a silicon-on-insulator (SOI) substrate, whereby the silicon is preferably mono-crystalline silicon and the insulator is preferably SiO₂;
(b) Etching alignment marks on top of the silicon top layer;
(c) Etching the recessive area surrounding the area of the inner electrode into the Si top layer down to the buried insulator layer, being preferably a SiO₂ layer;
(d) Oxidising the element to create a SiO₂ layer on top of the silicon top layer;
(e) Etching at least one back side cavity into a substrate layer by chemical Si etching or deep reactive-ion (DRIE) etching;
(f) Performing an oxide isotropic etching by wet or vapour HF to remove accessible oxide layers in order to release the area of the inner electrode and the buried insulator layer between said area and the back-side cavity;
(g) Optionally depositing a metal layer on the surface of the silicon top layer.

12. Method of producing an electrostatic biprism according to claim 10, comprising:
(a) Provision of a mono- or polycrystalline silicon substrate layer;
(b) Oxidation of the top surface of the silicon substrate layer to generate a SiO₂ layer as the second non-conductive layer,
(c) Deposition of a polycrystalline silicon layer on top of the non-conductive SiO₂-layer by epitaxy or by low pressure chemical vapour deposition (LPCVD) to generate said first conductive layer;
(d) Etching alignment marks on top of the silicon top layer;
(e) Etching the recessive area surrounding the area of the inner electrode into the Si top layer down to the buried SiO₂ insulator layer,
(f) Oxidising the element to create a SiO₂ layer on top of the silicon top layer;
(g) Etching at least one back side cavity into the substrate layer by chemical Si etching or deep reactive-ion (DRIE) etching;
(h) Performing an oxide isotropic etching by wet or vapour HF to remove accessible oxide layers in order to release the area of the inner electrode and the buried SiO₂ layer between said area and the back side cavity;
(i) Optionally depositing a metal layer on the surface of the silicon top layer.

13. Use of the electrostatic biprism according to claim 1 as an electron beam device for electron holography, filtering energy, transmission electron microscopy, generation of vortex electron beams, aberration corrections or phase plate.

14. Electron beam device comprising an electrostatic biprism according to claim 1.

15. Microscope or interferometer comprising an electrostatic biprism according to claim 1 or an electron beam device according claim 14.

## Patentansprüche

1. Elektrostatisches Doppelprisma, welches ein Streuen oder Ablenken eines Strahls geladener Partikel ermöglicht, um zwei verschiedene Partikelstrahlen zu erzeugen, mit einer ersten, leitfähigen Schicht, vorzugsweise einer mono- oder polykristallinen Schicht, die auf einer zweiten, nicht-leitfähigen Schicht angeordnet ist, welche auf einer Trägerschicht angeordnet ist, wobei mindestens ein Bereich der ersten, leitfähigen Schicht, welcher eine innere Elektrode als eine Mittelelektrode des elektrostatischen Doppelprismas bildet, von zwei benachbarten Bereichen der ersten, leitfähigen Schicht elektrisch isoliert ist, wobei die Trägerschicht einen Hohlraum unter der inneren Elektrode aufweist, die als eine freistehende Elektrode ohne darunter befindliche nicht-leitfähige Schicht und ohne darunter befindliche Trägerschicht und mit Spalten zwischen der inneren Elektrode und den beiden benachbarten Bereichen der ersten, leitfähigen Schicht ausgebildet ist.

2. Elektrostatisches Doppelprisma nach Anspruch 1, bei welchem die Dicke der ersten, leitfähigen Schicht, welche die Höhe der inneren Elektrode des elektrostatischen Doppelprismas definiert, zwischen 10 nm und 1 mm, vorzugsweise zwischen 0,1 µm und 10 µm und stärker bevorzugt zwischen 0.5 und 2 µm beträgt,
und/oder
die Dicke der zweiten, nicht-leitfähigen Schicht zwischen 1 nm und 100 µm, vorzugsweise zwischen 25 nm und 500 nm und stärker bevorzugt zwischen 50 und 200 nm beträgt.

3. Elektrostatisches Doppelprisma nach einem der vorhergehenden Ansprüche, bei welchem die Trägerschicht eine Dicke zwischen 1 nm und 10 nm, vorzugsweise 100 nm und 5 mm und stärker bevorzugt zwischen 500 µm und 1 mm aufweist.

4. Elektrostatisches Doppelprisma nach einem der vorhergehenden Ansprüche, bei welchem der Bereich der ersten, leitfähigen Schicht eine Form aufweist, die aus der Gruppe bestehend aus einer Spirale, einem Kreis, konzentrischen Kreisen und einem Rechteck gewählt ist.

5. Elektrostatisches Doppelprisma nach einem der vorhergehenden Ansprüche, bei welchem der Spalt zwischen dem Bereich, welcher die innere Elektrode bildet, und den beiden benachbarten Elektroden durch eine Ausnehmung in der inneren Elektrode und/oder den benachbarten Bereichen erweitert ist,
wobei die Ausnehmung vorzugsweise rechteckig, dreieckig oder kreisförmig mit einer Seitenlänge L4 innerhalb der ersten, leitfähigen Schicht, einer Seitenweite L1 innerhalb der ersten, leitfähigen Schicht und einer Seitenbreite L2 der verbleibenden ersten, leitfähigen Schicht der freistehenden Elektrode aufweist.

6. Elektrostatisches Doppelprisma nach Anspruch 5, bei welchem ein Seitenverhältnis zwischen der Breite L2 und einer Höhe L3 der freistehenden inneren Elektrode kleiner als 1:1, vorzugsweise kleiner als 1:5, stärker bevorzugt kleiner als 1:10 ist.
oder
das elektrostatische Doppelprisma eines oder mehrere der folgenden Merkmale aufweist:
(a) die Länge L4 liegt in einem Bereich zwischen 1 nm und 10 mm, vorzugsweise zwischen 1 µm und 1 mm und meist bevorzugt zwischen 1 µm und 100 µm;
(b) die Weite L1 liegt in einem Bereich zwischen 1 nm und 10 µm, vorzugsweise zwischen 10 nm und 1 µm und meist bevorzugt zwischen 50 nm und 500 nm;
(c) die Breite L2 der verbleibenden ersten, leitfähigen Schicht liegt in einem Bereich zwischen 1 nm und 100 µm, vorzugsweise zwischen 10 nm und 10 µm und meist bevorzugt zwischen 50 nm und 500 nm.

7. Elektrostatisches Doppelprisma nach einem der vorhergehenden Ansprüche, bei welchem die Substratschicht mindestens einen Hohlraum aufweist.

8. Elektrostatisches Doppelprisma nach einem der vorhergehenden Ansprüche, bei welchem das elektrostatische Doppelprisma 2 bis 1000 Bereiche einer inneren Elektrode aufweist, die von zwei benachbarten Bereichen der ersten, leitfähigen Schicht elektrisch isoliert sind, vorzugsweise 2 bis 100 Bereiche, stärker bevorzugt 2 bis 10 Bereiche und meist bevorzugt 2 bis 5 Bereiche.

9. Elektrostatisches Doppelprisma nach einem der vorhergehenden Ansprüche, bei welchem das elektrostatische Doppelprisma eines oder mehrere der folgenden Merkmale aufweist:
(a) eine Metallschicht, die vorzugsweise aus einem Metall besteht, das aus der Gruppe bestehend aus Al, AISi, Pt, Au und Ni gewählt ist, ist auf der ersten, leitfähigen Schicht aufgebracht;
(b) die erste, leitfähige Schicht besteht aus einem Material, das aus der Gruppe bestehend aus Si, AISi und Pt gewählt ist;
(c) die zweite, nicht-leitfähige Schicht besteht aus einem Material, das aus der Gruppe bestehend aus SiO₂, Si₃N₄ und HfO₂ gewählt ist;
(d) die Trägerschicht besteht aus einem Material, das aus der Gruppe bestehend aus mono- oder polykristallinem Silizium, GaAs, GaN, Al₂O₃, Pt und AI gewählt ist.

10. Verfahren zur Herstellung eines elektrostatischen Doppelprismas nach Anspruch 1, mit den folgenden Schritten:
(a) Vorsehen einer Schicht aus einem leitfähigen Material, welches auf einer auf einer Trägerschicht befindlichen Schicht aus einem nicht leitfähigen Material aufgebracht wird;
(b) Durchführen eines Photo-/Elektronenstrahllithografievorgangs, optional in Kombination mit Ätz- und/oder Oxidationsschritten, um mindestens einen Bereich der ersten, leitfähigen Schicht, der eine innere Elektrode bildet, als eine Mittelelektrode des elektrostatischen Doppelprismas vorzusehen, die von zwei benachbarten Bereichen der ersten, leitfähigen Schicht elektrisch isoliert ist, wobei die Trägerschicht einen Hohlraum unter der inneren Elektrode aufweist, die als eine freistehende Elektrode ohne darunter befindliche nicht-leitfähige Schicht und ohne darunter befindliche Trägerschicht und mit Spalten zwischen der inneren Elektrode und den beiden benachbarten Bereichen der ersten, leitfähigen Schicht ausgebildet ist.

11. Verfahren zur Herstellung eines elektrostatischen Doppelprismas nach Anspruch 10, mit den folgenden Schritten:
(a) Vorsehen eines Silicon-On-Insulator-Subsrats (SOI), wobei das Silizium vorzugsweise aus monokristallinem Silizium und der Isolator vorzugsweise aus SiO₂ besteht;
(b) Ätzen von Ausrichtungsmarken in die Oberseite der aus Silizium bestehenden oberen Schicht;
(c) Ätzen des den Bereich der inneren Elektrode umgebenden Ausnehmungsbereichs in die aus Silizium bestehende obere Schicht bis hinunter zur vergrabenen Isolatorschicht, welche vorzugsweise eine SiO₂-Schicht ist;
(d) Oxidieren des Elements, um eine SiO₂-Schicht auf der aus Silizium bestehenden oberen Schicht zu bilden;
(e) Ätzen mindestens eines Rückseitenhohlraums in eine Substratschicht durch chemisches Si-Ätzen oder Deep Reactive Ion Etching (DRIE);
(f) Durchführen von isotropem Oxidätzen mittels nassem oder dampfförmigem HF zum Entfernen von erreichbaren Oxidschichten, um den Bereich der inneren Elektrode und die vergrabene Isolatorschicht zwischen diesem Bereich und dem Rückseitenhohlraum freizulegen;
(g) optionales Aufbringen einer Metallschicht auf der Oberfläche der aus Silizium bestehenden oberen Schicht.

12. Verfahren zur Herstellung eines elektrostatischen Doppelprismas nach Anspruch 10, mit den folgenden Schritten:
(a) Vorsehen einer mono- oder polykristalline Siliziumsubstratschicht;
(b) Oxidieren der Oberseite der Siliziumsubstratschicht zur Bildung einer SiO₂-Schicht als die zweite, nicht leitfähige Schicht;
(c) Aufbringen einer polykristallinen Siliziumschicht auf der nicht leitfähigen SiO₂-Schicht durch Epitaxie oder durch chemische Niederdruck-Gasphasenabscheidung (LPCVD), um die erste, leitfähige Schicht zu bilden;
(d) Ätzen von Ausrichtungsmarken in die Oberseite der aus Silizium bestehenden oberen Schicht;
(e) Ätzen des den Bereich der inneren Elektrode umgebenden Ausnehmungsbereichs in die aus Silizium bestehende obere Schicht bis hinunter zur vergrabenen SiO₂-Isolatorschicht;
(f) Oxidieren des Elements, um eine SiO₂-Schicht auf der aus Silizium bestehenden oberen Schicht zu bilden;
(g) Ätzen mindestens eines Rückseitenhohlraums in eine Substratschicht durch chemisches Si-Ätzen oder Deep Reactive Ion Etching (DRIE);
(h) Durchführen von isotropem Oxidätzen mittels nassem oder dampfförmigem HF zum Entfernen von erreichbaren Oxidschichten, um den Bereich der inneren Elektrode und die vergrabene Isolatorschicht zwischen diesem Bereich und dem Rückseitenhohlraum freizulegen;
(i) optionales Aufbringen einer Metallschicht auf der Oberfläche der aus Silizium bestehenden oberen Schicht.

13. Verwendung des elektrostatischen Doppelprismas nach Anspruch 1 als eine Elektronenstrahlvorrichtung für die Elektronenholografie, das Filtern von Energie, die Transmissionselektronenmikroskopie, das Erzeugen von Vortexelektronenstrahlen, Aberrationskorrekturen oder als Phasenplatte.

14. Elektronenstrahlvorrichtung mit einem elektrostatischen Doppelprisma nach Anspruch 1.

15. Mikroskop oder Interferometer mit einem elektrostatischen Doppelprisma nach Anspruch 1 oder einer Elektronenstrahlvorrichtung nach Anspruch 14.

## Revendications

1. Biprisme électrostatique permettant une diffusion ou déflexion d'un faisceau de particules chargées pour générer deux faisceaux de particules différents comprenant une première couche conductrice, de préférence une couche mono- ou poly-cristalline, agencée sur une seconde couche non conductrice, qui est agencée sur le dessus d'une couche de support, dans lequel au moins une zone de ladite première couche conductrice formant une électrode interne en tant qu'électrode centrale du biprisme électrostatique est électriquement isolée de deux zones adjacentes de ladite première couche conductrice, dans lequel ladite couche de support possède une cavité en dessous de ladite électrode interne qui est formée comme une électrode autonome sans couche non conductrice sous-jacente et sans couche de support sous-jacente et avec des écartements entre l'électrode interne et les deux zones adjacentes de la première couche conductrice.

2. Biprisme électrostatique selon la revendication 1, dans lequel l'épaisseur de ladite première couche conductrice définissant la hauteur de l'électrode interne du biprisme électrostatique est comprise entre 10 nm et 1 mm, de préférence entre 0,1 µm et 10 µm et de manière davantage préférée entre 0,5 et 2 µm,
et/ou
l'épaisseur de ladite seconde couche non conductrice est comprise entre 1 nm et 100 µm, de préférence entre 25 nm et 500 nm et de manière davantage préférée entre 50 et 200 nm.

3. Biprisme électrostatique selon l'une quelconque des revendications précédentes, dans lequel la couche de support a une épaisseur comprise entre 1 nm et 10 mm, de préférence 100 nm et 5 mm et de manière davantage préférée 500 µm et 1 mm.

4. Biprisme électrostatique selon l'une quelconque des revendications précédentes, dans lequel la zone de la première couche conductrice englobe une forme choisie dans le groupe consistant en une spirale, un cercle, des cercles concentriques et un rectangle.

5. Biprisme électrostatique selon l'une quelconque des revendications précédentes, dans lequel l'écartement entre la zone formant l'électrode interne et les deux zones adjacentes est prolongé par un évidement de l'électrode interne et/ou des zones adjacentes,
de préférence l'évidement est rectangulaire, triangulaire ou circulaire avec une longueur latérale L4 au sein de la première couche conductrice, une largeur latérale L1 au sein de la première couche conductrice et une largeur latérale L2 de la première couche conductrice restante de l'électrode autonome.

6. Biprisme électrostatique selon la revendication 5, dans lequel un rapport de côté entre la largeur L2 et une hauteur L3 de l'électrode interne autonome est de moins de 1:1, de préférence de moins de 1:5, de manière davantage préférée de moins de 1:10 ; ou
ledit biprisme électrostatique présente une ou plusieurs des caractéristiques suivantes :
(a) la longueur L4 est dans une plage comprise entre 1 nm et 10 mm, de préférence entre 1 µm et 1 mm et de manière préférée entre toutes entre 1 µm et 200 µm ;
(b) la largeur L1 est dans une plage comprise entre 1 nm et 10 µm, de préférence entre 10 nm et 1 µm et de manière préférée entre toutes entre 50 nm et 500 nm ;
(c) la largeur L2 de la première couche conductrice restante est dans une plage comprise entre 1 nm et 100 µm, de préférence entre 10 nm et 10 µm et de manière préférée entre toutes entre 50 nm et 500 nm.

7. Biprisme électrostatique selon l'une quelconque des revendications précédentes, dans lequel la couche de substrat présente au moins une cavité.

8. Biprisme électrostatique selon l'une quelconque des revendications précédentes, dans lequel le prisme électrostatique contient 2 à 1 000 zones d'une électrode interne isolée de deux zones adjacentes de ladite première couche conductrice, de préférence 2 à 100 zones, de manière davantage préférée 2 à 10 zones et de manière préférée entre toutes 2 à 5 zones.

9. Biprisme électrostatique selon l'une quelconque des revendications précédentes, dans lequel ledit biprisme électrostatique présente une ou plusieurs des caractéristiques suivantes :
(a) une couche de métal est déposée au sommet de la première couche conductrice, de préférence consistant en un métal choisi dans le groupe consistant en Al, AlSi, Pt, Au et Ni ;
(b) la première couche conductrice consiste en un matériau choisi dans le groupe consistant en Si, AlSi et Pt ;
(c) la seconde couche non conductrice consiste en un matériau choisi dans le groupe consistant en SiO₂, Si₃N₄ et HfO₂ ;
(d) la couche de support consiste en un matériau choisi dans le groupe consistant en le silicium mono- ou poly-cristallin, GaAS, GaN, Al₂O₃, Pt et Al.

10. Procédé de production d'un biprisme électrostatique selon la revendication 1, comprenant :
(a) la fourniture d'une couche d'un matériau conducteur revêtu sur une couche d'un matériau non conducteur sur le dessus d'une couche de support ;
(b) la réalisation d'un processus lithographique à faisceau de photons/électrons, facultativement combiné à des étapes de gravure et/ou d'oxydation, afin de fournir au moins une zone de ladite première couche conductrice formant une électrode interne en tant qu'électrode centrale du biprisme électrostatique qui est électriquement isolée de deux zones adjacentes de ladite première couche conductrice, dans lequel ladite couche de support possède une cavité en dessous de ladite électrode interne qui est formée comme une électrode autonome sans couche non conductrice sous-jacente et sans couche de support sous-jacente et avec un écartement entre l'électrode interne et les deux zones adjacentes de la première couche conductrice.

11. Procédé de production d'un biprisme électrostatique selon la revendication 10, comprenant :
(a) la fourniture d'un substrat silicium sur isolant (SOI), dans lequel le silicium est de préférence du silicium monocristallin et l'isolant est de préférence SiO₂ ;
(b) la gravure de marques d'alignement au sommet de la couche de sommet en silicium ;
(c) la gravure de la zone évidée entourant la zone de l'électrode interne dans la couche de sommet en Si en descendant jusqu'à la couche d'isolant enfouie, qui est de préférence une couche de SiO₂ ;
(d) l'oxydation de l'élément pour créer une couche de SiO₂ au sommet de la couche de sommet en silicium ;
(e) la gravure d'au moins une cavité côté dorsal dans une couche de substrat par gravure chimique de Si ou gravure profonde par ions réactifs (DRIE) ;
(f) la réalisation d'une gravure isotrope d'oxyde par HF en phase humide ou vapeur pour éliminer des couches d'oxyde accessibles afin de libérer la zone de l'électrode interne et la couche d'isolant enfouie entre ladite zone et la cavité côté dorsal ;
(g) le dépôt facultatif d'une couche de métal sur la surface de la couche de sommet en silicium.

12. Procédé de production d'un biprisme électrostatique selon la revendication 10, comprenant :
(a) la fourniture d'une couche de substrat en silicium mono- ou poly-cristallin ;
(b) l'oxydation de la surface de sommet de la couche de substrat en silicium pour générer une couche de SiO₂ en tant que seconde couche non conductrice,
(c) le dépôt d'une couche de silicium polycristallin au sommet de la couche de SiO₂ non conductrice par épitaxie ou dépôt chimique en phase vapeur basse pression (LPCVD) pour générer ladite première couche conductrice ;
(d) la gravure de marques d'alignement au sommet de la couche de sommet en silicium ;
(e) la gravure de la zone évidée entourant la zone de l'électrode interne dans la couche de sommet en Si en descendant jusqu'à la couche d'isolant en SiO₂ enfouie,
(f) l'oxydation de l'élément pour créer une couche de SiO₂ au sommet de la couche de sommet en silicium ;
(g) la gravure d'au moins une cavité côté dorsal dans la couche de substrat par gravure de Si chimique ou gravure profonde par ions réactifs (DRIE) ;
(h) la réalisation d'une gravure isotrope d'oxyde par HF en phase humide ou vapeur pour éliminer des couches d'oxyde accessibles afin de libérer la zone de l'électrode interne et la couche de SiO₂ enfouie entre ladite zone et la cavité côté dorsal ;
(i) le dépôt facultatif d'une couche de métal sur la surface de la couche de sommet en silicium.

13. Utilisation du biprisme électrostatique selon la revendication 1, comme dispositif à faisceau d'électrons pour holographie à électrons, filtrer de l'énergie, microscopie électronique à transmission, génération de faisceaux d'électrons à vortex, corrections d'aberration ou lame de phase.

14. Dispositif à faisceau d'électrons comprenant un biprisme électrostatique selon la revendication 1.

15. Microscope ou interféromètre comprenant un biprisme électrostatique selon la revendication 1 ou un dispositif à faisceau d'électrons selon la revendication 14.
